Europäisches Patentamt

European Patent Office

Office européen des brevets

(11) Veröffentlichungsnummer: **0 374 495**
**A2**

(12) **EUROPÄISCHE PATENTANMELDUNG**

(21) Anmeldenummer: **89121372.0**

(22) Anmeldetag: **18.11.89**

(51) Int. Cl.5: **C08L 81/02, C08G 75/02,**
**F21V 7/22, C08J 7/06**

(30) Priorität: **01.12.88 DE 3840420**
**08.03.89 DE 3907473**

(43) Veröffentlichungstag der Anmeldung:
**27.06.90 Patentblatt 90/26**

(84) Benannte Vertragsstaaten:
**BE DE ES FR GB IT NL SE**

(71) Anmelder: **BAYER AG**

**D-5090 Leverkusen 1 Bayerwerk(DE)**

(72) Erfinder: **Stahlke, Kurt-Rainer, Dr.**
**Amselweg 20**
**D-5067 Kürten 2(DE)**
Erfinder: **Reinking, Klaus, Dr.**
**Robert-Stolz-Strasse 16b**
**D-5632 Wermelskirchen(DE)**
Erfinder: **Dorf, Ernst-Ulrich, Dr.**
**Bodelschwinghstrasse 16**
**D-4150 Krefeld(DE)**
Erfinder: **Sirinyan, Kirkor, Dr.**
**Humperdinckstrasse 12**
**D-5060 Bergisch-Gladbach 2(DE)**
Erfinder: **Thurm, Siegfried, Dr.**
**Am Damm 5a**
**D-4005 Meerbusch 3(DE)**

(54) **Polyarylensulfidformmassen mit verbesserter Metallhaftung.**

(57) Die Erfindung betrifft Formmassen aus neutralen Polyarylensulfiden (PAS), vorzugsweise neutralem Polyphenylensulfid (PPS) und daraus hergestellte reflektierende Gegenstände wie Leuchten, vorzugsweise Scheinwerfer und Rückstrahler.

EP 0 374 495 A2

## Polyarylensulfidformmassen mit verbesserter Metallhaftung

Die Erfindung betrifft Formmassen aus neutralen Polyarylensulfiden (PAS), vorzugsweise neutralem Polyphenylensulfid (PPS) und daraus hergestellte reflektierende Gegenstände wie Leuchten, vorzugsweise Scheinwerfer und Rückstrahler.

Aus Polyarylensulfiden hergestellte Spritzgußkörper zeigen wegen ihres üblicherweise hohen Füllstoffgehaltes nicht die Oberflächenqualitäten, die z.B. von amorphen Thermoplasten her bekannt sind. Damit sind Anwendungen, bei denen es auf hohe Oberflächenqualität ankommt, erschwert realisierbar. Dies gilt insbesondere, wenn Spritzgußteile noch oberflächenveredelt werden müssen, beispielsweise metallisiert. Oberflächenstörungen werden in der Regel durch Metallisierung deutlich sichtbar.

Eine Metallisierung von aus Polyarylensulfiden hergestellten Spritzgußkörpern ist kaum zu erreichen, da in den Polyarylensulfiden eingebaute niedermolekulare, vorzugsweise sauer ausgasende Komponenten, bei in der Praxis auftretenden Temperatur- und Feuchtigkeitsschwankungen bereits nach kurzer Zeit den metallisierten Gegenstand zerstörten. Dieses Problem wurde bislang z.B. durch aufwendige Einbrennlackierung von aus Polyarylensulfiden hergestellten Spritzgußkörpern behoben. Aufgrund von Nachtemperungs- und Nachkristallisationseffekten wurden derartig hergestellte Spritzgußkörper in der Praxis rißanfällig und versagten im Einsatz. Dies gilt besonders für Spritzgußkörper mit möglichst glatten Oberflächen, wie sie im optischen Bereich, vorzugsweise bei Leuchten, z.B. Reflektoren, eingesetzt werden.

Es wurde nun gefunden, daß Polyarylensulfidformmassen, vorzugsweise Polyphenylensulfidformmassen, für die obengenannten Anwendungen zum Einsatz kommen können, wenn die Formmasse nach Einbringen in ionenfreies Wasser den pH-Wert des Wassers annähernd neutral stellt.

Nach Verarbeitung der erfindungsgemäßen Formmassen mit üblichen Techniken wie z.B. Spritzguß, können die erhaltenen Gegenstände z.B. im Vakuum metallisiert werden. Es werden optisch hochwertige Spritzgußkörper erhalten, die nach Aufbringen der üblichen Schutzlackierungen oder Versiegelung mit Siliziumverbindungen, beispielsweise mit Trimethoxyvinylsilan, Triethoxyvinylsilan und Hexamethyldisiloxan, einem Temperatur- und Feuchtigkeitstest unterzogen werden. Nach den durchgeführten Tests zeigte sich keinerlei Beeinträchtigung der Metallschicht.

Gegenstand der Erfindung sind daher Formmassen aus

A) Polyarylensulfiden, vorzugsweise Polyphenylensulfid und

B) 0 bis 80 Gew.-%, vorzugsweise 10 bis 70 Gew.-%, besonders bevorzugt 20 bis 60 Gew.-% mineralischen Füllstoffen, dadurch gekennzeichnet, daß das Polyarylensulfid nach Einbringen in ionenfreies Wasser den pH-Wert des Wassers auf pH 6 bis 8,5 stellt, vorzugsweise 6,5 bis 7,5, besonders bevorzugt 6,7 bis 7,2 stellt.

Erfindungsgemäß verwendbare Polyarylensulfide, vorzugsweise Polyphenylensulfide für Komponente A sind bekannt (z.B. US-A 3 354 129, EP-A 171 021). Sie haben einen Viskositätsbereich von $\eta$ ~ 0,5 bis 300 Pas, vorzugsweise 26 bis 60 Pas. Die Messungen der Viskosität werden in einem Weissenberg Rheogoniometer bei 306° C und einer Schergeschwindigkeit von $10^3$ sec$^{-1}$ durchgeführt.

Als ionenfreies Wasser kann z.B.. übliches destilliertes oder mit Ionenaustauschern entionisiertes Wasser eingesetzt werden.

Als Füllstoffe für Komponente B dienen mineralische Füllstoffe und Füllstoffe mit geringer MOHS'scher Härte. Sie haben Härtegrade bis 6 auf der MOHS'schen Härteskala. Geeignete mineralische Füllstoffe haben vorzugsweise annähernd kugelförmige Geometrie.

Als Füllstoffe mit geringen Härtegraden können z.B. ((Erd)Alkali)Carbonate wie $MgCO_3$, $CaCO_3$, Ca-Mg-Carbonat, Silikate wie Al-Silikat, Ca-Al-Silikat sowie Siliciumdioxid eingesetzt werden. Als mineralische Füllstoffe können anorganische Gläser, insbesondere ionenarmes E-Glas, z.B. in kugeliger Form, vorzugsweise Glaskugeln, Graphit, Metalloxide, insbesondere Titandioxid und ZnO eingesetzt werden. Diese Füllstoffe können schuppenförmige Geometrie aufweisen.

Es werden Füllstoffkombinationen aus Füllstoffen mit geringer MOHS'schen Härte und mineralischen Füllstoffen eingesetzt, die aus 40 bis 60 Gew.-%, vorzugsweise 35 bis 45 Gew.-% eines mineralischen Füllstoffes bestehen, und 0 bis 30 Gew.-%, vorzugsweise 10 bis 15 Gew.-% eines schuppenförmigen Füllstoffes, sowie anorganisches Glas, vorzugsweise in kugeliger Gestalt, z.B. Micro E-Glaskugeln in 0 bis 30 Gew.-%, vorzugsweise 10 bis 15 Gew.-%, enthalten. Microglaskugeln haben einen mittleren Durchmesser von 3 bis 30 μm, vorzugsweise von 5 bis 8 μm.

Gegebenenfalls können zur zusätzlichen Stabilisierung der lichtreflektierenden Metallauflagen die PPS-Matrix mit den Salzen, Oxiden und/oder mit organometallischen Verbindungen des Zinns bzw. des Zinks zugesetzt werden, z. B. ZnO, $ZnSO_4$, SnO, $SnSO_4$, Zinkgluconat, Zinkhexafluorsilikat, Zinkborat, Zinkphosphat usw.. Es können 0,05 bis 10,0 Gew.-% (bezogen auf die PPS-Menge) zugesetzt werden, vorzugsweise 0,1 bis 5,0 Gew.-%,

besonders bevorzugt 0,5 bis 3,0 Gew.-%.

Zum Aufbringen von gut haftenden Metallauflagen kann eine Plasmabehandlung - oder Flammen- bzw. Coronabehandlung vorgenommen werden, vorzugsweise eine Plasmabehandlung .

Die Plasmabehandlung ist an sich bekannt. Zur Durchführung der Plasmabehandlung sind sowohl herkömmliche Plasmaanlagen, wie beispielsweise HF (Hochfrequenz)-Plasma im Frequenzbereich von beispielsweise 27,12 bis 13,56 MHz als auch Mikrowellenplasmaanlagen im Frequenzbereich, beispielsweise von 2,45 GHz (v. beispielsweise M. Neusch et. al.: Vakuum, 34, 959 (1984)) und insbesondere kombinierte Systeme HF-Plasma mit Magnetfeldunterstützung, geeignet.

Zur Durchführung der Plasmareaktion können sowohl Inert-als auch Reaktivgase eingesetzt werden. Für das erfindungsgemäße Verfahren besonders geeignet sind $O_2$, $N_2$, He, Ar, $F_2$, $Cl_2$, $Br_2$, niedermolekulare Fluorkohlenstoffverbindungen wie $C_2F_4$, $CF_4$, Perfluorpropen und Perfluorcyclohexan, bis zu einem gewissen Grade ($C_8$) Alkene oder Alkane, z. B. Cyclohexen, ferner $H_2S$, $SO_3$, $SO_2$, $NH_3$, $NO_2$, $N_2O_5$ bzw. deren Mischungen untereinander.

Die Behandlungszeit kann von 0,1 sec bis zu mehreren Minuten variiert werden, wobei Behandlungszeiten von 1 bis 360 sec bevorzugt, von 10 bis 120 sec besonders bevorzugt sind. Man arbeitet in der Regel bei einem Gasdruck zwischen 0,01 und 100 mbar, vorzugsweise zwischen 0,1 und 10 mbar.

Die Behandlungstemperatur kann von Raumtemperatur bis 160° C variiert werden, wobei Temperaturen von 30 bis 60° C bevorzugt sind.

Selbstverständlich können die Probenmaterialien vor oder nach der Plasmabehandlung mit üblichen nicht ätzenden Flüssigkeiten wie Wasser, Alkoholen (vorzugsweise Ethanol, Methanol, Isopropanol), Ketonen wie Aceton, Methylethylketon, Chlorkohlenwasserstoffen wie Tetrachlorethylen, $CCl_4$, 1.1.1-Trichlorethan, 1.1.2.2.-Tetrachlorethan, Kohlenwasserstoffen wie n-Hexan, n-Pentan, Ligroin, Petrolether, Waschbenzin, Dimethylformamid, Dimethylsulfoxid bzw. deren Mischung untereinander entfettet werden. Zur Erhöhung der Reinigungswirkung können diese Lösemitel mit neutralen, anionischen und kationischen Tensiden bzw. mit quarternären Aminen, z. B. in Mengen von 0,1 bis 5,0 Gew.-% versetzt werden, z.B. mit Tetrabutylammoniumbromid, Dimethylbenzylammoniumchlorid, Benzoesulfonsäure-Na-salz, Isononylphenolheptaglykolether usw..

Die erfindungsgemäßen Abmischungen lassen sich nach bekannten Methoden wie Vakuumbedampfung, z.B. Schulz, H., Plastverarbeiter, 16, 459 (1965) und Wachendorf, H., Plastverarbeiter, 11, 82 (1960), Gasplattierung, z.B. R Springer, Kunststoffe, 42, 354 (1952) und Metallspritzer, z.B. R Reichherzer, Kunststoff-Rundschau, 18, 106 (1971)) mit Metallen wie Cu, Ni, Co, Au, Ag und Al beschichten. Vorzugsweise werden sie mit Aluminium vakuumbedampft.

Die Schichtdicke der Metallauflage beträgt 0,01 μm bis 7,5 μm, vorzugsweise 0,1 μm bis 1,0 μm.

Die Metallauflage kann z.B. im Plasma mit einer Polysiloxanauflage, z.B. auf Basis von Trimethoxysiloxan, Triethoxysiloxan, Hexamethyldisiloxan usw. beschichtet werden.

Die erfindungsgemäßen Abmischungen eignen sich in vorteilhafter Weise vorzugsweise zur Herstellung von Spritzgußkörpern mit hochwertigen Oberflächenqualitäten, die problemlos und dauerhaft direkt, ohne Aufbringen einer Lackschicht, metallisierbar sind (beschichtet werden können).

Vorzugsweise werden aus den erfindungsgemäßen Formmassen Formteile hergestellt, die nach Beschichtung für reflektierende Formkörper für Fortbewegungsmittel, vorzugsweise für den Automobilbau, verwendet werden. Solche reflektierenden Formkörper sind beispielsweise Leuchten wie (Scheinwerfer) Reflektoren, vorzugsweise Automobilscheinwerfer, Rücklichter, Bremslichter, Begrenzungslampen, Blinklichter, Nebelleuchten usw..

Beispiele

Beispiel 1

Zur Herstellung der Formmassen wird ein handelsübliches Polyarylensulfid, z B. Tedur®, verwendet, das erfindungsgemäß in ionenfreies Waser eingebracht den pH-Wert des Wassers nahezu neutral stellt. Dazu wurden z.B. 10 g eines zerkleinerten Polyarylensulfid-Granulats solange mit vorzugsweise entionisiertem Wasser behandelt, bis diese 10 g, eingebracht in 1 l enionisiertes Wasser, den pH-Wert des Wassers auf pH 6 bis 8,5 stellen.

Beispiel 2 (Vergleichsbeispiel)

In einer konventionellen Spritzgußmaschine wird z.B. ein Polyphenylensulfid gemäß EP-A 171 021 mit 45 Gew.-% handelsüblichen Glasfasern (10 bis 15 μ Durchmesser) compoundiert. Das Material weist eine Viskosität von $\eta$ = 1,3 x $10^2$ Pas bei einer Schergeschwindigkeit von $\gamma$ = $10^3$ x $sec^{-1}$ auf, gemessen bei 320° C. Es werden daraus Reflektoren für den Kfz-Bereich durch konventionelles Spritzgießen hergestellt. Nach anschließender Vakuummetallisierung (z.B. mit Aluminium) zeigt der Reflektor eine rauhe Oberfläche, die beim Einsatz für Autoscheinwerfer nicht geeignet ist.

## Beispiel 3

Ein in Beispiel 1 beschriebenes Polyphenylensulfid wird mit 30 Gew.-% eines handelsüblichen $TiO_2$ (Bayer Titan RFKD) sowie 30 Gew.-% Glaskugeln (Ballotini 5000 E-CP 0,5) compoundiert. Die daraus hergestellten Reflektoren werden im Vakuum ($10^{-3}$ bar) nach bekannten Methoden (nach praxisüblicher Plasmavorbehandlung) mit Aluminium bedampft. Nach Durchführung der oben beschriebenen Klimatests zeigt sich keinerlei Veränderung der Aluminiumoberfläche, beim Tesatest (Scotch Tape Test) wird die Benotung 0 erhalten.

## Beispiel 4

Ein in Beispiel 1 beschriebenes Grundharz wird mit 30 Gew.-% Ca-Mg-Carbonat (Dolomit), 15 Gew.-% eines handelsüblichen Graphits sowie 15 % Ballotini E CP 5000 0,3 compoundiert. Die daraus hergestellten Reflektoren werden im Vakuum mit Aluminium bedampft. Man erhält Verbundhaftungen, die im Tesa-Film-Test (Scotch Tape Test) keine Schädigung des Aluminiums (Note 0) (vergl. hierzu DIN 53 151) erkennen lassen [auch nach Temperatur- (DIN 50 017) und Feuchtigkeitstest (DIN 53 496)].

Bei diesen Tests werden erfindungsgemäß hergestellte Formkörper beispielsweise 24 Stunden bei 40° C in 85 % rel. Luftfeuchtigkeit gelagert oder einem Temperaturwechsel unterzogen, z.B. 6 Stunden bei -20° C, 6 Stunden bei 40° C und 95 % rel. Luftfeuchtigkeit, 6 Stunden -20° C, 6 Stunden 85° C (insgesamt 5 Cyclen). Der Formkörper kann bei erhöhter Temperatur in Gegenwart von Detergentien (z.B. 10 %ige Na-Lauryl-Sulfatlösung bei 60° C über 72 Stunden) gelagert werden.

Nach Durchführung der oben bechriebenen Klimatests zeigen sich keinerlei Veränderung der Aluminiumoberfläche, beim Tesatest wird die Benotung 0 erhalten.

Bei der Durchführung des Tesa-Tests (z.B. Scotch tape Test) wird z.B. ein 2 cm breiter und 5 cm langer handelsüblicher Tesa-Streifen (z.B. Scotch-tape, Tesa-Film) aufgeklebt und langsam wieder abgezogen. Läßt sich der Streifen abziehen, ohne daß die Metallisierung (teilweise) zerstört wird, wird die Benotung 0 gegeben. Bei der Zerstörung der metallisierten Oberfläche (Haften der Metallschicht auf dem Tesa-Streifen) wird die Bewertung -10 gegeben.

## Beispiel 5

Eine in Beispiel 1 beschriebene Grundharzplatte, welche noch zusätzlich 1,0 Gew.-% $ZnSiF_6$

enthält, wird auf die untere Elektrode des HF-Plasmarreaktors gelegt. Der Plasmareaktor wird mit technischem Argon gespült, anschließend auf einen Druck von ca 0,6 mbar evakuiert und das Ar-Plasma gezündet. Die Arbeitsfrequenz des Plasmasystems beträgt 27,12 MHz, die Elektrodentemperatur ca. 30° C und die Leistung ca. 140 Watt. Die Proben werden nach einer Reaktionszeit von ca. 45 sec. aus dem Reaktor entfernt.

Anschließend wird die Platte im Vakuum mit einer 1,0 μm Al-Auflage versehen und dann auf diese Auflage im Plasma eine Polysiloxanschicht der Schichtdicke von 2 μm auf Basis von Hexamethylendisiloxan aufgebracht. Man bekommt eine Verbundplatte mit hervorragender Metallhaftung, die Auflage besteht den Gitterschnittest nach DIN 53 151 mit Gt = 0, den Bewitterungstest nach DIN 50 017, den Temperaturwechseltest nach DIN 53 496 hervorragend.

## Beispiel 6

Eine in Beispiel 1 beschriebene Harzplatte, welche nach zusätzlich 2 Gew.-% Zinkborat enthält, wird nach Beispiel 5 mit Helium plasmabehandelt, mit einer Al- und anschließend einer Polysiloxanauflage nach Beispiel 5 beschichtet.

Man bekommt eine Verbundplatte mit sehr guter Metallhaftung und hervorragender Reflektionseigenschaft. Die Auflage besteht den Gitterschnittest nach DIN 53 151 mit Gt = 0. Ihre Bewitterungs- und Temperaturwechseleigenschaften nach DIN 50 017 und 53 496 sind hervorragend.

## Ansprüche

1. Formmassen aus
A) Polyarylensulfiden, vorzugsweise Polyphenylensulfid und
B) 0 bis 80 Gew.-% mineralischen Füllstoffen, dadurch gekenzeichnet, daß das Polyarylensulfid gegebenenfalls nach Einbringen in ionenfreies Wasser den pH-Wert des Wassers auf pH 6 bis 8,5 stellt.

2. Verwendung von Formmassen nach Anspruch 1 zur Herstellung von geformten Körpern, welche gegebenenfalls mit Metallen beschichtet sind.

3. Formkörper nach Anspruch 2, dadurch gekennzeichnet, daß das Metall im Vakuum aufgedampft ist.

4. Formkörper nach Anspruch 2, dadurch gekennzeichnet, daß Aluminium als Metall verwendet wird.

5. Formkörper nach Anspruch 2, dadurch gekennzeichnet, daß eine Plasmabehandlung vorgenommen wird.

6. Formkörper nach Anspruch 2, dadurch gekennzeichnet, daß die Metallauflage im Plasma mit einer Polysiloxanauflage auf Basis von Trimethoxy-, Triethoxyvinylsilan oder Hexamethyldisiloxan beschichtet wird.

7. Formmassen nach Anspruch 1, dadurch gekennzeichnet, daß sie ZnO und/oder SnO und/oder ZnSO$_4$ und/oder SnSO$_4$ und/oder Zn-hexafluorsilikat und/oder -borat und/oder -phosphat enthalten.

8. Leuchte etnhaltend Formmassen des Anspruchs 1.